# EUROPEAN PATENT SPECIFICATION

(11) **EP 4 012 787 B1**
(45) Date of publication and mention of the grant of the patent: **03.01.2024**
(21) Application number: 20849156.3
(22) Date of filing: 05.08.2020
(51) Int. Cl.: H10N 10/13, H02N 11/00

(54) **THERMOELECTRIC CONVERSION ELEMENT**
THERMOELEKTRISCHES UMWANDLUNGSELEMENT
ÉLÉMENT DE CONVERSION THERMOÉLECTRIQUE

(30) Priority: 08.08.2019 JP 2019146664
(43) Date of publication of application: 15.06.2022
(73) Proprietor: Denka Company Limited, Tokyo 103-8338 (JP)
(72) Inventor: ASAMI, Takeshi, Tokyo 103-8338 (JP); GOTO, Yoshitsugu, Tokyo 103-8338 (JP)
(74) Representative: Gulde & Partner
(86) International application number: PCT/JP2020/029999
(87) International publication number: WO 2021/025060

(56) References cited:
- EP-A1- 3 035 397
- WO-A1-2015/046253
- WO-A1-2018/143185
- WO-A1-2018/143185

## Description

### Technical Field

The present disclosure relates to a thermoelectric conversion element.

### Background Art

A thermoelectric conversion element may be used to perform power generation using geothermal heat, exhaust heat of a factory, or the like. JP 4,895,293 B2 discloses an embodiment in which a flexible substrate having a pattern layer and composed of a resin layer and a metal layer is provided on both surfaces of a thermoelectric conversion module having a P-type thermoelectric element material and an N-type thermoelectric element material. In JP 4,895,293 B2, a metal layer included in one flexible substrate overlaps one electrode included in the thermoelectric conversion module, and a metal layer included in the other flexible substrate overlaps the other electrode included in the thermoelectric conversion module. In the above embodiment, by setting one flexible substrate to a high temperature state and setting the other flexible substrate to a low temperature state, a temperature difference is generated in a planar direction of the thermoelectric conversion module. Accordingly, an electromotive force is generated in the thermoelectric conversion module.

EP 3 035 397 A1 discloses a thermally conductive adhesive sheet comprising a base material comprising a high thermally conductive portion and a low thermally conductive portion; and an adhesive layer, wherein the adhesive layer is laminated on one face of the base material, and the other face of the base material is composed of a face of the low thermally conductive portion opposite to a face in contact with the adhesive layer and a face of the high thermally conductive portion opposite to a face in contact with the adhesive layer, or at least either the high thermally conductive portion or the low thermally conductive portion constitutes a portion of a thickness of the base material, and a method for producing the thermally conductive adhesive sheet, and an electronic device using the thermally conductive adhesive sheet. WO 2018/143185 A1 discloses a thermoelectric conversion module comprising: a film-type thermoelectric conversion element body having p-type thermoelectric conversion elements and n-type thermoelectric conversion elements joined in one direction in a plane; and heat conductors joined to where the p-type thermoelectric conversion elements and the n-type thermoelectric conversion elements are joined on one surface of the thermoelectric conversion element body. Insulation regions are disposed adjoining both sides of the heat conductors in said one direction and, if disposed on the heat source, have radiation reflecting bodies and/or radiation prevention bodies closer to the heat source than the thermoelectric conversion element body.

### Summary of Invention

### Technical Problem

In the thermoelectric conversion element as described above, further improvement in thermoelectric conversion efficiency is required. Therefore, an object of an aspect of the present disclosure is to provide a thermoelectric conversion element capable of improving thermoelectric conversion efficiency.

### Solution to Problem

A thermoelectric conversion element according to the present invention is as follows.

The thermoelectric conversion element according to the present invention includes a substrate including a first main face and a second main face located on the opposite side of the first main face, a first electrode provided on the first main face, an n-type thermoelectric conversion layer electrically connected to the first electrode, a p-type thermoelectric conversion layer in contact with the n-type thermoelectric conversion layer, and a second electrode electrically connected to the p-type thermoelectric conversion layer, a sealing layer provided on the first main face, the sealing layer covering the first electrode, the n-type thermoelectric conversion layer, the p-type thermoelectric conversion layer, and the second electrode, and a first high thermal conduction portion, a second high thermal conduction portion, and a low thermal conduction portion provided only on the second main face, wherein the first electrode, the n-type thermoelectric conversion layer, the p-type thermoelectric conversion layer, and the second electrode are arranged in order along an alignment direction orthogonal to a thickness direction of the substrate, wherein the first electrode is overlapped with the first high thermal conduction portion in the thickness direction, the second electrode is overlapped with the second high thermal conduction portion in the thickness direction, a contact portion between the n-type thermoelectric conversion layer and the p-type thermoelectric conversion layer is overlapped with the low thermal conduction portion in the thickness direction, and the sealing layer constitutes the outermost layer located on the first face.

According to one embodiment of the thermoelectric conversion element of the present invention, the thermal conductivity of the low thermal conduction portion is 0.2W/mK or less.

According to a preferred embodiment of the thermoelectric conversion element of the present invention, the thermal conductivity of the low thermal conduction portion is 0.08W/mK or less.

According to a further embodiment of the thermoelectric conversion element of the present invention, the thermal conductivity of the first high thermal conduction portion and a thermal conductivity of the second high thermal conduction portion are 5W/mK or more.

According to a further embodiment of the thermoelectric conversion element of the present invention, the thermal conductivity of the first electrode and a thermal conductivity of the second electrode are 5W/mK or more.

According to a further embodiment of the thermoelectric conversion element of the present invention, the substrate has a flexibility.

According to a further embodiment of the thermoelectric conversion element of the present invention, the interval from the first high thermal conduction portion to the contact portion along the alignment direction is greater than or equal to 5 times a length of the first high thermal conduction portion along the thickness direction, and an interval from the second high thermal conduction portion to the contact portion along the alignment direction is greater than or equal to 5 times a length of the second high thermal conduction portion along the thickness direction.

### Advantageous Effects of Invention

According to the present invention, a thermoelectric conversion element capable of improving thermoelectric conversion efficiency can be provided.

### Brief Description of Drawings

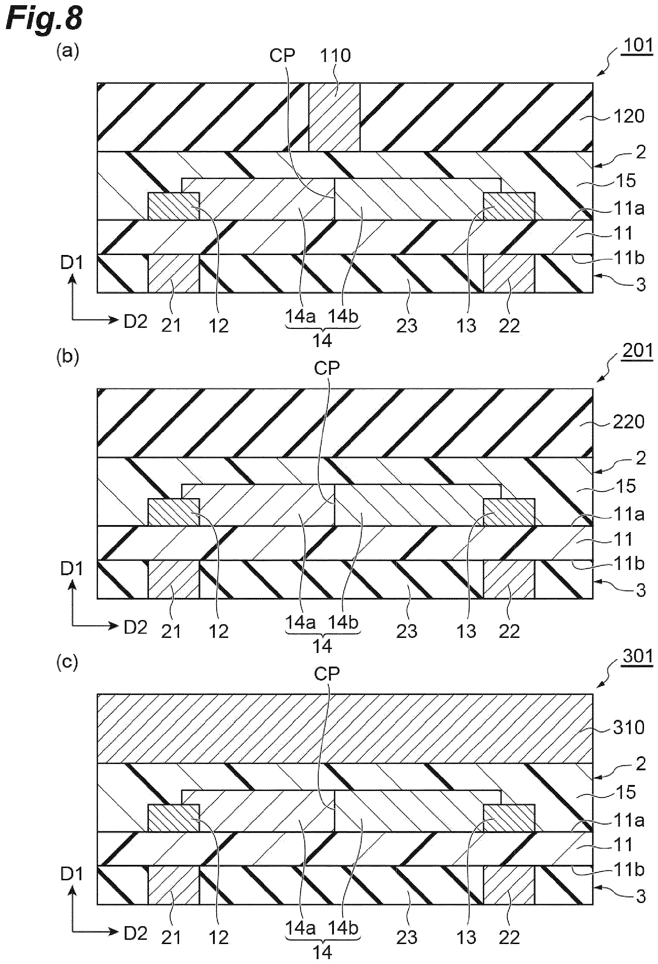

FIG. 1 is a schematic cross-sectional view showing a thermoelectric conversion element according to the present embodiment.
FIG. 2 is a schematic cross-sectional view showing a first simulation condition.
   (a) and (b) of FIG. 3 are graphs showing first simulation results.
FIG. 4 is a schematic cross-sectional view showing a second simulation condition.
FIG. 5 is a graph showing second simulation results.
FIG. 6 is a schematic cross-sectional view showing a third simulation condition.
FIG. 7 is a graph showing third simulation results.
   (a) of FIG. 8 is a schematic cross-sectional view of a thermoelectric conversion element according to a first reference example, (b) of FIG. 8 is a schematic cross-sectional view of a thermoelectric conversion element according to a second reference example, and (c) of FIG. 8 is a schematic cross-sectional view of a thermoelectric conversion element according to a third reference example.

### Description of Embodiments

Hereinafter, embodiments of the present disclosure will be described in detail with reference to the accompanying drawings. In the following description, the same element or the element having the same function is denoted by the same reference numeral, and redundant description is omitted. The term "identical" and similar terms used herein are not limited to "completely identical".

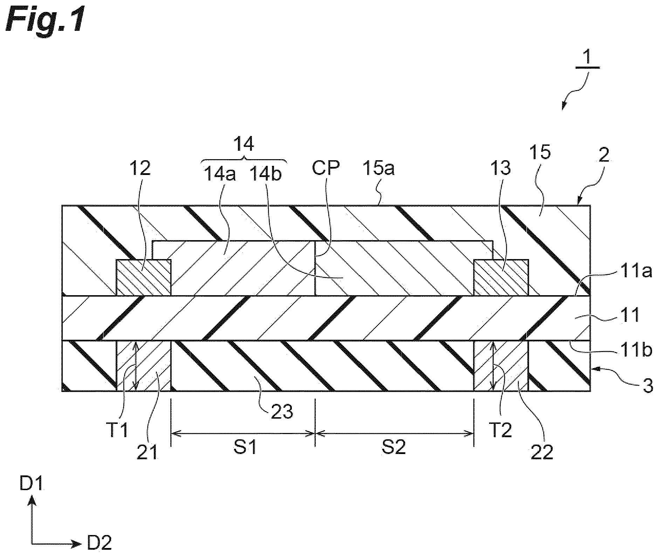

First, a configuration of a thermoelectric conversion element according to a present embodiment will be described with reference to FIG. 1. FIG. 1 is a schematic cross-sectional view showing a thermoelectric conversion element according to the present embodiment. The thermoelectric conversion element 1 shown in FIG. 1 is an element capable of generating electric power by being supplied with heat from the outside. The thermoelectric conversion element 1 is, for example, an element that converts heat into electricity by using a temperature difference in the thermoelectric conversion element 20. The thermoelectric conversion element 1 is a so-called in-plane type element. Therefore, the thermoelectric conversion element 1 is likely to be more excellent in workability and flexibility than, for example, a π-type element (cross-plane type element). Therefore, the thermoelectric conversion element 1 can be provided along the side surface of a cylindrical pipe or the like used for recovering factory exhaust heat, for example. That is, the thermoelectric conversion element 1 can be easily disposed at various positions. Therefore, the thermoelectric conversion element 1 is used, for example, as a power source of a plant sensor using exhaust heat. In addition, the contact resistance between the thermoelectric conversion material included in the thermoelectric conversion element 1 and the electrode is likely to be lower than that of the π-type module. In the following, the temperature of each component of the thermoelectric conversion element 1 is measured under natural convection conditions of air.

The thermoelectric conversion element 1 includes a thermoelectric conversion module 2 and a sheet member 3. The thermoelectric conversion module 2 is a thermoelectric conversion portion in the thermoelectric conversion element 1, and includes a substrate 11, a first electrode 12, a second electrode 13, an element portion 14, and a sealing layer 15.

The substrate 11 is, for example, a sheet member made of a resin exhibiting heat resistance and flexibility, and has a substantially flat plate shape. Examples of the resin constituting the substrate 11 include a (meth) acrylic based resin, a (meth) acrylonitrile based resin, a polyamide based resin, a polycarbonate based resin, a polyether based resin, a polyester based resin, an epoxy based resin, an organosiloxane based resin, a polyimide based resin, and a polysulfone based resin. The thickness of the substrate 11 is, for example, 5µm or more and 50µm or less. The thermal conductivity of the substrate 11 is, for example, 0.1W/mK (corresponding to 0.1 watts per meter per Kelvin and 0.1W× m⁻¹ × K⁻¹) or more and 0.3W/mK or less. When the thermal conductivity of the substrate 11 is 0.3W/mK or less, a temperature difference may occur in the element portion 14. The substrate 11 has a first main face 11a and a second main face 11b located on the opposite side of the first main face 11a. The first main face 11a and the second main face 11b are faces intersecting the direction along the thickness of the substrate 11. The shapes of the first main face 11a and the second main face 11b are not particularly limited, and are, for example, polygonal, circular, elliptical, or the like. Hereinafter, the direction along the thickness of the substrate 11 is simply referred to as a thickness direction D1. A view from the thickness direction D1 corresponds to a plan view.

The first electrode 12 is a member constituting a terminal included in the thermoelectric conversion module 2, and is a conductor provided on the first main face 11a of the substrate 11. The first electrode 12 is a conductor made of, for example, a metal, an alloy, or a conductive resin. When the first electrode 12 is made of a metal or an alloy, the first electrode 12 is formed on the substrate 11 by various dry methods, for example. Examples of the dry method include a physical vapor deposition method (PVD method) and patterning of a metal foil or an alloy foil. The first electrode 12 may be formed using a nano-paste or the like in which metal particles are dispersed. The shape of the first electrode 12 in a plan view is not particularly limited, and is, for example, a polygonal shape, a circular shape, an elliptical shape, or the like. The thickness of the first electrode 12 is, for example, 6µm or more and 70µm or less. The thermal conductivity of the first electrode 12 is, for example, 5W/mK or more. In this case, the first electrode 12 is likely to be easily heated from the outside. The thermal conductivity of the first electrode 12 may be, for example, 30W/mK or more.

The second electrode 13 is a member constituting a terminal included in the thermoelectric conversion module 2 similarly to the first electrode 12, and is a conductor provided on the first main face 11a of the substrate 11. The second electrode 13 is separated from the first electrode 12. The second electrode 13 is formed at the same time as the first electrode 12. Therefore, the second electrode 13 is made of the same material as the first electrode 12. The shape of the second electrode 13 in a plan view is not particularly limited, and is, for example, a polygonal shape, a circular shape, an elliptical shape, or the like. Similarly to the first electrode 12, the thermal conductivity of the second electrode 13 is, for example, 5W/mK or more. The thermal conductivity of the second electrode 13 may be, for example, 30W/mK or more.

The element portion 14 is a member in which thermoelectric conversion is performed in the thermoelectric conversion module 2. The shape of the element portion 14 in a plan view is not particularly limited, and is, for example, a polygonal shape, a circular shape, an elliptical shape, or the like. The element portion 14 includes an n-type thermoelectric conversion layer 14a and a p-type thermoelectric conversion layer 14b. In the present embodiment, the n-type thermoelectric conversion layer 14a and the p-type thermoelectric conversion layer 14b have the same shape.

The n-type thermoelectric conversion layer 14a is disposed on the first main face 11a of the substrate 11 and electrically connected to the first electrode 12. In this embodiment, the n-type thermoelectric conversion layer 14a is located between the first electrode 12 and the second electrode 13 and is in contact with the first electrode 12. The n-type thermoelectric conversion layer 14a covers a part of the first electrode 12. The n-type thermoelectric conversion layer 14a is, for example, an n-type semiconductor layer. The n-type thermoelectric conversion layer 14a includes, for example, a composite of an inorganic substance and an organic substance or a composite of a plurality of organic substances. Examples of the inorganic substance include titanium disulfide (TiS₂), bismuth tellurium (Bi₂Te₃), skutterudite, and nickel (Ni). The inorganic substance may be titanium disulfide (TiS₂). Examples of the organic substance include an n-type single-walled carbon nanotube (SWCNT) and tetrathiafulvalene-tetracyanoquinodimethane (TTF-TCNQ). The n-type thermoelectric conversion layer 14a is formed by various dry methods or wet methods, for example. Examples of the wet method include a doctor blade method, a dip coating method, a spray coating method, a spin coating method, and an inkjet method. The thickness of the n-type thermoelectric conversion layer 14a is, for example, 9µm or more and 200µm or less. The thermal conductivity of the n-type thermoelectric conversion layer 14a is, for example, 0.01W/mK or more and 0.5W/mK or less. In this case, a temperature gradient may be easily formed in the n-type thermoelectric conversion layer 14a. The thickness of the n-type thermoelectric conversion layer 14a corresponds to the thickness of the portion not overlapped with the first electrode 12 in the thickness direction D1.

The p-type thermoelectric conversion layer 14b is provided on the first main face 11a of the substrate 11 and is in contact with the n-type thermoelectric conversion layer 14a. In the present embodiment, the p-type thermoelectric conversion layer 14b is located between the first electrode 12 and the second electrode 13, and is located opposite to the first electrode 12 with the n-type thermoelectric conversion layer 14a interposed therebetween. The p-type thermoelectric conversion layer 14b covers a part of the second electrode 13 and is in contact with the part. The p-type thermoelectric conversion layer 14b is, for example, a p-type semiconductor layer. The p-type thermoelectric conversion layer 14b includes, for example, a carbon nanotube and a conductive polymer different from the carbon nanotube. The carbon nanotube is, for example, a p-type SWCNT. Examples of the conductive polymer include poly (3,4-ethylenedioxythiophene) (PEDOT) and polystyrene sulfonate (PSS). In the p-type thermoelectric conversion layer 14b, the carbon nanotube and the conductive polymer may aggregate. The p-type thermoelectric conversion layer 14b may include a porous structure in which carbon nanotubes are bonded to each other by a conductive polymer.

The p-type thermoelectric conversion layer 14b is formed by, for example, various dry or wet methods, similarly to the n-type thermoelectric conversion layer 14a. The thickness of the p-type thermoelectric conversion layer 14b is, for example, 9µm or more and 200µm or less. The thermal conductivity of the p-type thermoelectric conversion layer 14b is, for example, 0.01W/mK or more and 0.5W/mK or less. In this case, a temperature gradient may be easily formed in the p-type thermoelectric conversion layer 14b. The thickness of the p-type thermoelectric conversion layer 14b corresponds to the thickness of the portion not overlapped with the second electrode 13 in the thickness direction D1.

The sealing layer 15 is a resin layer for protecting the first electrode 12, the second electrode 13, the n-type thermoelectric conversion layer 14a, and the p-type thermoelectric conversion layer 14b, and constitutes the outermost layer of the thermoelectric conversion element 1 located on the first main face 11a. In the present embodiment, the outermost layer is formed only of the sealing layer 15. The sealing layer 15 is provided on the first main face 11a and covers the first electrode 12, the second electrode 13, the n-type thermoelectric conversion layer 14a, and the p-type thermoelectric conversion layer 14b. Examples of the resin constituting the sealing layer 15 include a (meth) acrylic based resin, a (meth) acrylonitrile based resin, a polyamide based resin, a polycarbonate based resin, a polyether based resin, a polyester based resin, an epoxy based resin, an organosiloxane based resin, a polyimide based resin, and a polysulfone based resin. The thickness of the sealing layer 15 is, for example, 50µm or more and 200µm or less, and is smaller than intervals S1 and S2 described later. The thermal conductivity of the sealing layer 15 is, for example, 0.01W/mK or more and 0.5W/mK or less.

The first electrode 12, the n-type thermoelectric conversion layer 14a, the p-type thermoelectric conversion layer 14b, and the second electrode 13 are disposed in order along an alignment direction D2 orthogonal to the thickness direction D1. For example, the first electrode 12 is located at one end of the thermoelectric conversion module 2 in the alignment direction D2, and the second electrode 13 is located at the other end of the thermoelectric conversion module 2 in the alignment direction D2. In view of the difference in thermal conductivity between the components of the thermoelectric conversion module 2, for example, when the thermoelectric conversion module 2 is heated from a side of the substrate 11, the temperature of the portion of the n-type thermoelectric conversion layer 14a in contact with the first electrode 12 is likely to be the highest, and the temperature of the portion of the p-type thermoelectric conversion layer 14b in contact with the second electrode 13 is likely to be the highest. The temperature of a contact portion CP between the n-type thermoelectric conversion layer 14a and the p-type thermoelectric conversion layer 14b is likely to be the lowest. Therefore, in each of the n-type thermoelectric conversion layer 14a and the p-type thermoelectric conversion layer 14b, a temperature gradient may occur along the alignment direction D2. In a plan view, the contact portion CP extends along a direction intersecting both the thickness direction D1 and the alignment direction D2, for example. In a plan view, the contact portion CP may have a linear shape, a wavy line shape, or an arc shape.

A length of the n-type thermoelectric conversion layer 14a along the alignment direction D2 is longer than a length of the sealing layer 15 along the thickness direction D1. The length of the n-type thermoelectric conversion layer 14a along the alignment direction D2 is, for example, 5 times or more or 10 times or more longer than the length of the sealing layer 15 along the thickness direction D1. As described above, the thermal conductivity of the sealing layer 15 is, for example, 0.1W/mK or more and 0.5W/mK or less. For this reason, for example, heat conducted from the first electrode 12 to the sealing layer 15 more easily reaches the upper face 15a of the sealing layer 15 than the contact portion CP. In other words, the contact portion CP is less likely to conduct heat through the sealing layer 15. Rather, the heat of the contact portion CP is likely to be discharged to the outside through the sealing layer 15.

The sheet member 3 is a member disposed between the thermoelectric conversion module 2 and the heat source, and is provided on the second main face 11b of the substrate 11. Therefore, the heat generated from the heat source is conducted to the thermoelectric conversion module 2 through the sheet member 3. The sheet member 3 has a first high thermal conduction portion 21, a second high thermal conduction portion 22, and a low thermal conduction portion 23.

The first high thermal conduction portion 21 and the second high thermal conduction portion 22 are portions exhibiting higher thermal conductivity than the low thermal conduction portion 23, and are spaced apart from each other. The first high thermal conduction portion 21 is overlapped with the first electrode 12 in the thickness direction D1, and the second high thermal conduction portion 22 is overlapped with the second electrode 13 in the thickness direction D1. The shapes of the first high thermal conduction portion 21 and the second high thermal conduction portion 22 in a plan view are not particularly limited, and are, for example, polygonal shape, circular shape, elliptical shape, or the like. In a plan view, the shape of the first high thermal conduction portion 21 and the shape of the first electrode 12 may be the same as or different from each other. Similarly, in a plan view, the shape of the second high thermal conduction portion 22 and the shape of the second electrode 13 may be the same as or different from each other. Each of the first high thermal conduction portion 21 and the second high thermal conduction portion 22 includes, for example, a metal (silver, copper, aluminum, or the like), carbon, or the like. Each of the first high thermal conduction portion 21 and the second high thermal conduction portion 22 may include a ceramic such as boron nitride or aluminum nitride exhibiting high thermal conductivity. The thermal conductivity of each of the first high thermal conduction portion 21 and the second high thermal conduction portion 22 is, for example, 5W/mK or more and 400W/mK or less. Accordingly, when the sheet member 3 is heated, heat is transferred to the first electrode 12 and the second electrode 13 through the first high thermal conduction portion 21 and the second high thermal conduction portion 22, respectively.

From the viewpoint of increasing the heat transfer efficiency from the first high thermal conduction portion 21 to the first electrode 12, the first electrode 12 may be located inside the edge of the first high thermal conduction portion 21 in a plan view, or the edge of the first electrode 12 and the edge of the first high thermal conduction portion 21 may be completely overlapped with each other. Similarly, in a plan view, the second electrode 13 may be located inside the edge of the second high thermal conduction portion 22, or the edge of the second electrode 13 and the edge of the second high thermal conduction portion 22 may be completely overlapped with each other. From the viewpoint of widening the temperature gradient along the alignment direction D2 inside the n-type thermoelectric conversion layer 14a, the first high thermal conduction portion 21 may be located closer to one end side in the alignment direction D2 than the first electrode 12. That is, in a plan view, the edge of the first high thermal conduction portion 21 on the one end side may be located outside the edge of the first electrode 12 on the one end side. Similarly, the second high thermal conduction portion 22 may be located closer to the other end side in the alignment direction D2 than the second electrode 13.

A length T1 of the first high thermal conduction portion 21 along the thickness direction D1 is, for example, not less than 50µm and not more than 500µm. In a plan view, an interval S1 from the first high thermal conduction portion 21 (a contact portion between the first high thermal conduction portion 21 and the low thermal conduction portion 23) to the contact portion CP along the alignment direction D2 is, for example, 5 times or more or 10 times or more longer than the length T1 of the first high thermal conduction portion 21. In this case, a temperature gradient in the n-type thermoelectric conversion layer 14a along the alignment direction D2 may be favorably generated. Similarly, a length T2 of the second high thermal conduction portion 22 along the thickness direction D1 is, for example, not less than 50µm and not more than 500µm. In a plan view, an interval S2 from a second high thermal conduction portion 22 (a contact portion between the second high thermal conduction portion 22 and the low thermal conduction portion 23) to the contact portion CP along the alignment direction D2 is, for example, 5 times or more or 10 times or more longer than the length T2 of the second high thermal conduction portion 22. In this case, a temperature gradient in the p-type thermoelectric conversion layer 14b along the alignment direction D2 may be favorably generated. Depending on the length T1 of the first high thermal conduction portion 21, the interval S1 may be 5 times or more, 10 times or more, or 20 times or less longer than the length T1. Similarly, the interval S2 may be 5 times or more, 10 times or more, or 20 times or less longer than the length T2. For example, when the length T1 is greater than or equal to 100µm and less than or equal to 200µm, the interval S1 is preferably greater than or equal to 5 times the length T1, more preferably greater than or equal to 10 times the length T1.

The low thermal conduction portion 23 is a portion having a lower thermal conductivity than the first high thermal conduction portion 21 and the second high thermal conduction portion 22, and is a main portion of the sheet member 3. The low thermal conduction portion 23 is overlapped with at least the contact portion CP in the thickness direction D1 and covers most of the second main face 11b. In the present embodiment, the low thermal conduction portion 23 is overlapped with most of the n-type thermoelectric conversion layer 14a and the p-type thermoelectric conversion layer 14b in addition to the contact portion CP in the thickness direction D1. The low thermal conduction portion 23 fills the gap between the first high thermal conduction portion 21 and the second high thermal conduction portion 22 in the alignment direction D2. The low thermal conduction portion 23 includes, for example, cellulose nanofibers (CNF), silica aerogel, or the like. The low thermal conduction portion 23 may be a foam body.

The thermal conductivity of the low thermal conduction portion 23 is significantly lower than the thermal conductivity of the first high thermal conduction portion 21 and the second high thermal conduction portion 22, and is, for example, 0.01W/mK or more and 0.2W/mK or less. Accordingly, when the sheet member 3 is heated, a portion of the thermoelectric conversion module 2 located on the first main face 11a and overlapped with the low thermal conduction portion 23 is less likely to be heated. Accordingly, since the contact portion CP and the vicinity thereof are less likely to be heated, the temperature gradient in the n-type thermoelectric conversion layer 14a and the temperature gradient in the p-type thermoelectric conversion layer 14b along the alignment direction D2 may be favorably generated. From the viewpoint of better generating the temperature gradient, the thermal conductivity of the low thermal conduction portion 23 may be 0.08W/mK or less.

The sheet member 3 is formed directly on the second main face 11b, for example. In this case, each of the first high thermal conduction portion 21, the second high thermal conduction portion 22, and the low thermal conduction portion 23 is formed by various dry or wet methods. Alternatively, the sheet member 3 may be attached to the second main face 11b with an adhesive (not shown). Examples of the adhesive include a (meth) acrylic based resin, a (meth) acrylonitrile based resin, a polyamide based resin, a polycarbonate based resin, a polyether based resin, a polyester based resin, an epoxy based resin, an organosiloxane based resin, a polyimide based resin, and a polysulfone based resin. The thermal conductivity of the adhesive is, for example, approximately the same as the thermal conductivity of the substrate 11.

The thermoelectric conversion element 1 may further include a configuration other than the above. For example, the thermoelectric conversion element 1 may include a wiring for electrically connecting another thermoelectric conversion element, a wiring for extracting power to an external circuit, and the like.

In the thermoelectric conversion element 1 according to the present embodiment described above, the first electrode 12 is overlapped with the first high thermal conduction portion 21 in the thickness direction D1, the second electrode 13 is overlapped with the second high thermal conduction portion 22 in the thickness direction D1, and the contact portion CP between the n-type thermoelectric conversion layer 14a and the p-type thermoelectric conversion layer 14b is overlapped with the low thermal conduction portion 23 in the thickness direction D1. Accordingly, when the thermoelectric conversion module 2 is heated from a side of the sheet member 3, in the n-type thermoelectric conversion layer 14a, the temperature of the contact portion CP is likely to be the lowest, and the temperature of the portion closest to the first electrode 12 is likely to be the highest. Similarly, in the p-type thermoelectric conversion layer 14b, the temperature of the contact portion CP is likely to be the lowest, and the temperature of the portion closest to the second electrode 13 is likely to be the highest. In this case, for example, both the temperature gradient of the n-type thermoelectric conversion layer 14a in the alignment direction D2 and the temperature gradient of the p-type thermoelectric conversion layer 14b in the alignment direction D2 are likely to be larger than when a side of one electrode is brought into a high temperature state and a side of the other electrode is brought into a low temperature state in the alignment direction D2. In other words, both the temperature difference between both ends of the n-type thermoelectric conversion layer 14a in the alignment direction D2 and the temperature difference between both ends of the p-type thermoelectric conversion layer 14b in the alignment direction D2 are likely to be larger than when the side of one electrode is set to a high temperature state and the side of the other electrode is set to a low temperature state in the alignment direction D2. In addition, since the sealing layer 15 constitutes the outermost layer located on the first main face 11a, the temperature gradient is likely to be maintained. Therefore, according to the thermoelectric conversion element 1 of the present embodiment, the thermoelectric conversion efficiency can be improved.

In the present embodiment, the thermal conductivity of the low thermal conduction portion 23 may be 0.2W/mK or less. In this case, the temperature difference between both ends of each of the n-type thermoelectric conversion layer 14a and the p-type thermoelectric conversion layer 14b in the alignment direction D2 can be favorably widened. When the thermal conductivity of the low thermal conduction portion 23 is 0.08W/mK or less, the temperature difference can be more favorably widened.

In the present embodiment, the thermal conductivity of the first high thermal conduction portion 21 and the thermal conductivity of the second high thermal conduction portion 22 may be 5W/mK or more. In this case, the temperature difference between both ends of each of the n-type thermoelectric conversion layer 14a and the p-type thermoelectric conversion layer 14b in the alignment direction D2 can be favorably widened.

In the present embodiment, the thermal conductivity of the first electrode 12 and the thermal conductivity of the second electrode 13 may be 5W/mK or more. In this case, the temperature difference between both ends of each of the n-type thermoelectric conversion layer 14a and the p-type thermoelectric conversion layer 14b in the alignment direction D2 can be favorably widened.

In the present embodiment, the substrate 11 has a flexibility. Therefore, the thermoelectric conversion element 1 can exhibit have a flexibility. Therefore, for example, the thermoelectric conversion element 1 can be easily provided along the surface of the cylindrical pipe. That is, it is possible to alleviate the restriction on the mounting position of the thermoelectric conversion element 1.

In this embodiment, the interval S2 from the first high thermal conduction portion 21 to the contact portion CP along the alignment direction D2 is at least 5 times or at least 10 times longer than the length T1 of the first high thermal conduction portion 21 along the thickness direction D1, and the interval S2 from the second high thermal conduction portion 22 to the contact portion CP along the alignment direction D2 is at least 5 times or at least 10 times longer than the length T2 of the second high thermal conduction portion 22 along the thickness direction D1. Therefore, the temperature difference between both ends of each of the n-type thermoelectric conversion layer 14a and the p-type thermoelectric conversion layer 14b in the alignment direction D2 can be favorably widened.

In the following, results of simulating a temperature change in the element when a position or a characteristic of a constituent element included in the thermoelectric conversion element is changed will be described. In the following simulations, a two dimensional model is set. In the following simulation, an EXCEL model in which a basic differential equation of two dimensional heat conduction was applied to differentiation was used. A finite volume method was applied as a method of differentiation.

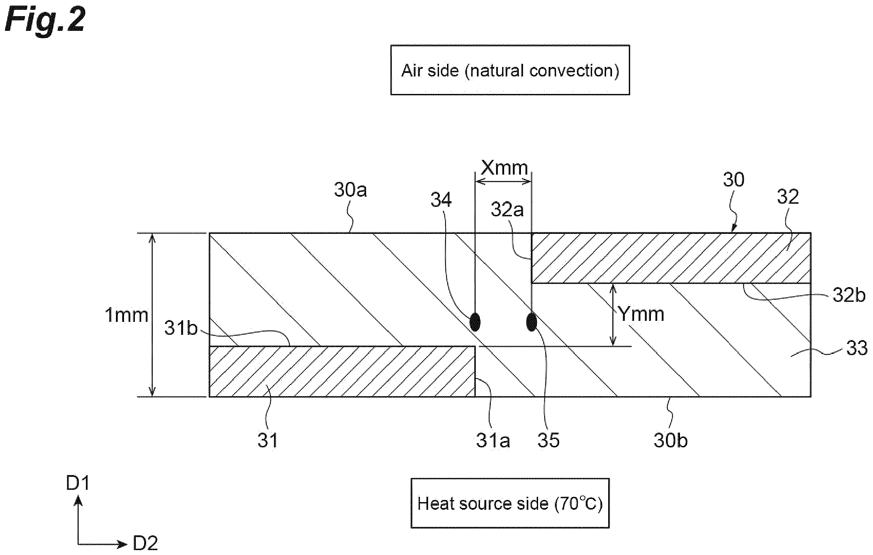

FIG. 2 is a schematic cross-sectional view showing a first simulation condition. As shown in FIG. 2, a model 30 in the first simulation includes a high thermal conduction portions 31, 32 and a low thermal conduction portion 33 similarly to the sheet member 3 of the above embodiment. The high thermal conduction portion 31 is exposed on one side in the thickness direction D1 and is located at one end of the model 30 in the alignment direction D2. The high thermal conduction portion 32 is exposed on the other side in the thickness direction D1 and is located at the other end of the model 30 in the alignment direction D2. In the model 30, the dimension of the high thermal conduction portions 31,32 along the thickness direction D1 was set to be the same. The low thermal conduction portion 33 had a sheet shape with a thickness of 1mm, and was integrated with the high thermal conduction portions 31, 32. The thermal conductivity of the high thermal conduction portions 31, 32 was set to 398W/mK, and the thermal conductivity of the low thermal conduction portion 33 was set to 0.3W/mK.

In the model 30, the interval between the high thermal conduction portions 31, 32 along the alignment direction D2 is defined as an interval X (mm), and the interval between the high thermal conduction portions 31, 32 along the thickness direction D1 is defined as an interval Y (mm) (interval Y is less than 1). When the interval X is 0mm, the edge 31a on the center side of the high thermal conduction portion 31 in the alignment direction D2 is overlapped with the edge 32a on the center side of the high thermal conduction portion 32 in the alignment direction D2 in the thickness direction D1. When the interval Y is 0mm, the edge 31b on the center side of the high thermal conduction portion 31 in the thickness direction D1 is overlapped with the edge 32b on the center side of the high thermal conduction portion 32 in the thickness direction D1 in the alignment direction D2.

In the model 30, two temperature evaluation points 34, 35 are set. The temperature evaluation point 34 is located at the center of the interval Y on the edge 31a on the center side of the high thermal conduction portion 31 in the thickness direction D1. Therefore, when the interval Y is 0mm, the temperature evaluation point 34 is overlapped with the intersection of the edges 31a and 31b. The temperature evaluation point 35 is located at the center of the interval Y on the edge 32a on the center side of the high thermal conduction portion 32 in the thickness direction D1. Therefore, when the interval Y is 0mm, the temperature evaluation point 35 is overlapped with the intersection of the edges 32a and 32b.

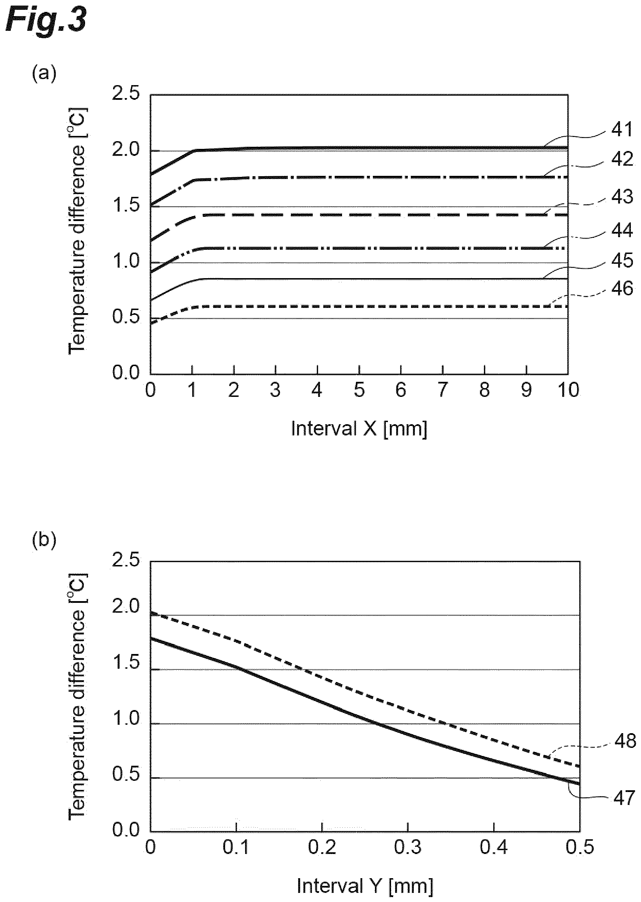

In the thickness direction D1, the one side of the model 30 is set as a side of the heat source, and the other side of the model 30 is set as a side of air. In the first simulation, the temperature on the side of the heat source is set to 70°C, and the side of air is set to room temperature (23°C). In the first simulation, the surface 30b of the model 30 located on the side of heat source in the thickness direction D1 is heated by natural convection and the surface 30a of the model 30 located on the side of air in the thickness direction D1 is cooled by natural convection.
(a) and (b) of FIG. 3 are graphs showing results of the first simulation. (a) of FIG. 3 is a graph showing a change in the temperature difference at the temperature evaluation points 34, 35 when the interval X is changed. In (a) of FIG. 3, the horizontal axis represents the interval X, and the vertical axis represents the temperature difference at the temperature evaluation points 34, 35. A plot 41 shows a simulation result when the interval Y is 0mm, a plot 42 shows a simulation result when the interval Y is 0.1mm, a plot 43 shows a simulation result when the interval Y is 0.2mm, a plot 44 shows a simulation result when the interval Y is 0.3mm, a plot 45 shows a simulation result when the interval Y is 0.4mm, and a plot 46 shows a simulation result when the interval Y is 0.5mm. As shown in (a) of FIG. 3, under the condition that the interval X is 1mm or less, the temperature difference at the temperature evaluation points 34, 35 increases as the interval X increases, regardless of the value of the interval Y Under the condition that the interval X was 1mm or more and less than 2mm, the temperature difference was unlikely to increase even when the interval X was increased. Under the condition that the interval X was 2mm or more, the temperature difference was not substantially changed even when the interval X was widened regardless of the value of the interval Y This suggests that, for example, in the sheet member 3 of the above embodiment, when the distance between the first high thermal conduction portion 21 and the second high thermal conduction portion 22 in the alignment direction D2 is 2mm or more, the distance between the first high thermal conduction portion 21 and the second high thermal conduction portion 22 in the thickness direction D1 may not be considered.
(b) of FIG. 3 is a graph showing a change in the temperature difference of the temperature evaluation points 34, 35 when the interval Y is changed. In (b) of FIG. 3, the horizontal axis represents the interval Y, and the vertical axis represents the temperature difference at the temperature evaluation points 34, 35. A plot 47 shows a simulation result when the interval X is 0mm, and a plot 48 shows a simulation result when the interval X is 10mm. As shown in (b) of FIG. 3, regardless of the value of the interval X, the shorter the interval Y, the larger the temperature difference at the temperature evaluation points 34, 35. This suggests that, for example, in the model 30, the shorter the interval Y of the high thermal conduction portions 31, 32 in the thickness direction D1, the larger the temperature difference.

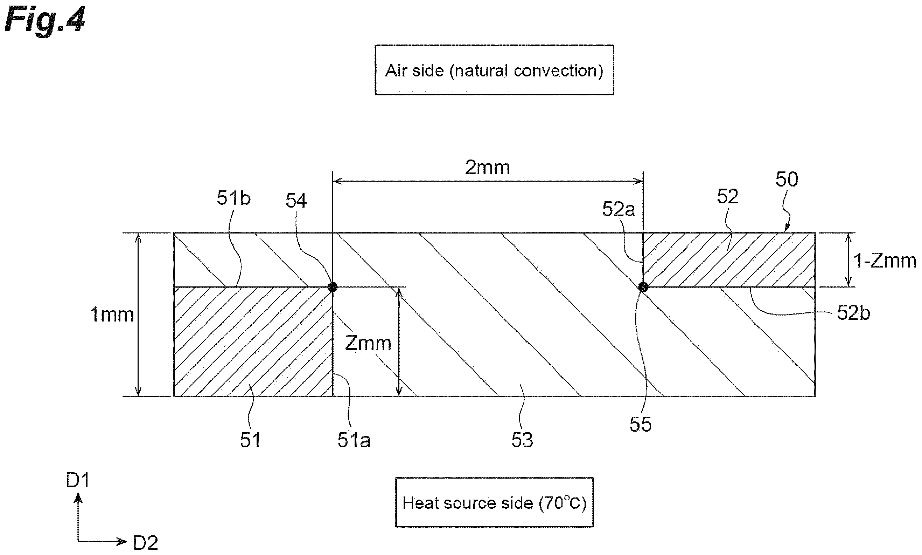

FIG. 4 is a schematic cross-sectional view showing a second simulation condition. As shown in FIG. 4, a model 50 in the simulation of second includes a high thermal conduction portions 51,52 and a low thermal conduction portion 53 similarly to the model 30. The positions where the high thermal conduction portions 51, 52 and the low thermal conduction portion 53 are provided in the model 50, and the thermal conductivities thereof are the same as those of the model 30. In model 50, the interval between the high thermal conduction portions 51, 52 along the alignment direction D2 was set to 2mm. The length of the high thermal conduction portion 52 along the thickness direction D1 was set to Z mm, and the length of the high thermal conduction portion 51 along the thickness direction D1 was set to 1-Z mm. The ambient temperature condition of the model 50 is the same as that in the first simulation.

In the model 50, two temperature evaluation points 54, 55 are set. The temperature evaluation point 54 is located at the intersection of the center side edge 51a of the high thermal conduction portion 51 along the alignment direction D2 and the center side edge 51b of the high thermal conduction portion 51 along the thickness direction D1. The temperature evaluation point 55 is located at the intersection of the center side edge 52a of the high thermal conduction portion 52 along the alignment direction D2 and the center side edge 52b of the high thermal conduction portion 52 along the thickness direction D1.

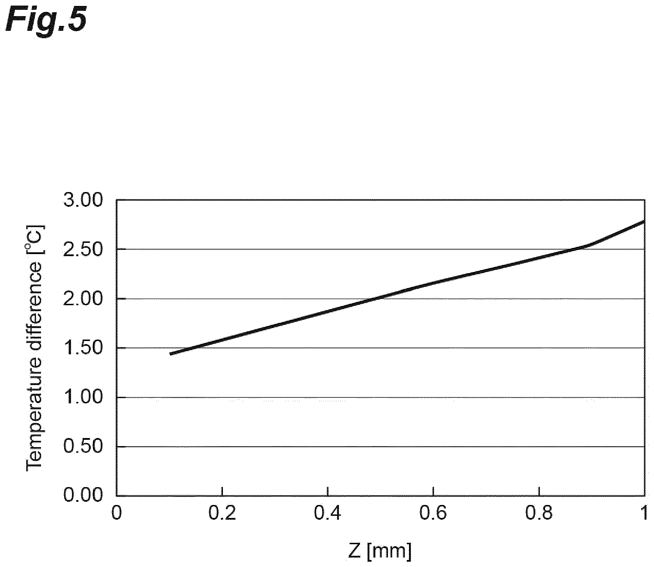

FIG. 5 is a graph showing results of the second simulation, and shows a change in temperature difference of the temperature evaluation points 54, 55 when the height of the high thermal conduction portion 51 along the thickness direction D1 is changed. In FIG. 5, the horizontal axis represents the length Z, and the vertical axis represents the temperature difference at the temperature evaluation points 54, 55. As shown in FIG. 5, the larger the length along the thickness direction D1 of the high thermal conduction portion 51 located on the side of heat source in the thickness direction D1, the larger the temperature difference. From this result, it is suggested that in order to widen the temperature difference of the temperature evaluation points 54, 55 along the alignment direction D2 in the model 50, it is effective to increase the thickness of the high thermal conductive portion located on the side of heat source as much as possible.

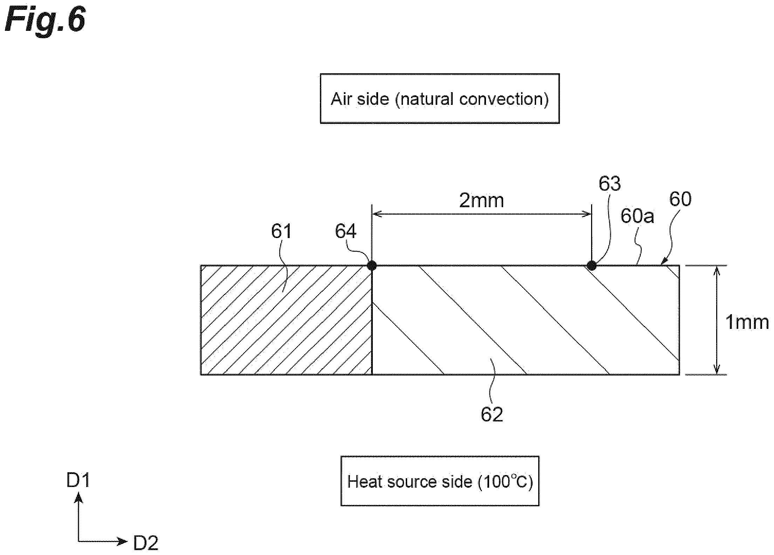

FIG. 6 is a schematic cross-sectional view showing a third simulation condition. Based on the first and second simulation results, the model used in the third simulation has a structure in which it is estimated that the largest temperature difference occurs in the alignment direction D2. Specifically, as shown in FIG. 6, a model 60 in the third simulation includes a high thermal conduction portion 61 and a low thermal conduction portion 62. The high thermal conduction portion 61 and the low thermal conduction portion 62 are arranged in order along the alignment direction D2 and are integrated with each other. The dimensions of the high thermal conduction portion 61 and the low thermal conduction portion 62 along the thickness direction D1 are 1mm. The thermal conductivity of the high thermal conduction portion 61 is set to 398W/mK.

In the thickness direction D1, the one side of the model 60 is set as the side of heat source, and the other side of the model 60 is set as the side of air. In the third simulation, unlike the first simulation, the temperature on the side of heat source is set to 100°C. On the other hand, the side of air has the same conditions as in the first simulation.

In the model 60, a temperature evaluation point 63 located on surface 60a of the model 60 is set. The temperature evaluation point 63 is located on the low thermal conduction portion 62 at a distance of 2mm along the alignment direction D2 from the contact portion 64 between the high thermal conduction portion 61 and the low thermal conduction portion 62. Therefore, the temperature of temperature evaluation point 63 indicates the temperature of surface 60a when the model 60 is heated (more specifically, the temperature of surface 60a formed of the low thermal conduction portion 62).

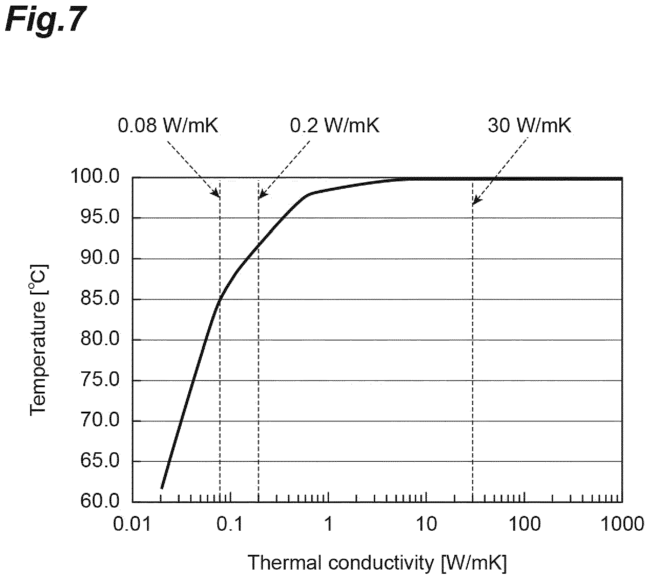

FIG. 7 is a graph showing results of the third simulation, and shows a temperature change of the temperature evaluation point 63 when the heat conductivity of the low thermal conduction portion 62 is changed. In FIG. 7, the horizontal axis represents the thermal conductivity of the low thermal conduction portion 62, and the vertical axis represents the temperature of the temperature evaluation point 63. As shown in FIG. 7, the lower the thermal conductivity of the low thermal conduction portion 62, the lower the temperature of the temperature evaluation point 63. When the thermal conductivity of the low thermal conduction portion 62 was 0.2W/mK, the temperature difference between the heat source and the temperature evaluation point 63 was about 8°C. When the thermal conductivity of the low thermal conduction portion 62 was 0.08W/mK, the temperature difference between the heat source and the temperature evaluation point 63 was about 15°C. Meanwhile, when the thermal conductivity of the low thermal conduction portion 62 was 30W/mK or more, the temperature difference between the heat source and the temperature evaluation point 63 was almost 0. This suggests that, for example, when the thermal conductivity of the low thermal conduction portion 23 included in the sheet member 3 is 0.2W/mK or less, the low thermal conduction portion 23 is likely to exhibit good thermal insulation properties, and when the thermal conductivity of the low thermal conduction portion 23 is 0.08W/mK or less, the low thermal conduction portion 23 is likely to exhibit better thermal insulation properties.

Next, simulation results of the maximum temperature difference in the element portion when the configuration of the thermoelectric conversion element is changed will be described. (a) of FIG. 8 is a schematic cross-sectional view of a thermoelectric conversion element according to a first reference example, (b) of FIG. 8 is a schematic cross-sectional view of a thermoelectric conversion element according to a second reference example, and (c) of FIG. 8 is a schematic cross-sectional view of a thermoelectric conversion element according to a third reference example.

The thermoelectric conversion element 101 shown in (a) of FIG. 8 includes a high thermal conduction portion 110 and a low thermal conduction portion 120 provided on the sealing layer 15 in addition to the components of the thermoelectric conversion element 1. The high thermal conduction portion 110 is provided to improve heat dissipation of the n-type thermoelectric conversion layer 14a and the p-type thermoelectric conversion layer 14b, and is overlapped with the contact portion CP in the thickness direction D1. The center of the high thermal conduction portion 110 in the alignment direction D2 is overlapped with the contact portion CP in the thickness direction D1. The low thermal conduction portion 120 is a sheet member provided to reduce heat dissipation of the first electrode 12, the second electrode 13, and their vicinity. The low thermal conduction portion 120 surrounds the high thermal conduction portion 110 in a direction orthogonal to the thickness direction D1 and is overlapped with the first electrode 12, the second electrode 13, the first high thermal conduction portion 21, and the second high thermal conduction portion 22 in the thickness direction D1. Lengths of the high thermal conduction portion 110 and the low thermal conduction portion 120 along the thickness direction D1 are the same.

The thermoelectric conversion element 201 shown in (b) of FIG. 8 includes a low thermal conduction portion 220 provided on the sealing layer 15 in addition to the components of the thermoelectric conversion element 1. The low thermal conduction portion 220 is a sheet member covering the upper face of the sealing layer 15. Length of the low thermal conduction portion 220 along the thickness direction D1 is the same as the length of the high thermal conduction portion 110 and the low thermal conduction portion 120 along the thickness direction D1 shown in (a) of FIG. 8.

The thermoelectric conversion element 301 shown in (c) of FIG. 8 includes a high thermal conduction portion 310 provided on the sealing layer 15 in addition to the components of the thermoelectric conversion element 1. The high thermal conduction portion 310 is a sheet member covering the upper face of the sealing layer 15. Length of the high thermal conduction portion 310 along the thickness direction D1 is the same as the length of the high thermal conduction portion 110 and the low thermal conduction portion 120 along the thickness direction D1 shown in (a) of FIG. 8.

In this simulation, in the thermoelectric conversion elements 1, 101, 201, 301, the length of the thermoelectric conversion module 2 along the thickness direction D1 was set to 0.6 mm, the length of the substrate 11 along the thickness direction D1 was set to 50µm, the length of the sheet member 3 along the thickness direction D1 was set to 400µm, and the lengths of the thermoelectric conversion module 2 and the sheet member 3 along the alignment direction D2 were set to 15mm. The length of the thermoelectric conversion module 2 along the thickness direction D1 does not include the lengths of the high thermal conduction portions 110, 310 along the thickness direction D1 and the lengths of the low thermal conduction portions 120, 220 along the thickness direction D1. The lengths of the first electrode 12 and the second electrode 13 along the thickness direction D1 were set to 25µm, the lengths of the n-type thermoelectric conversion layer 14a and the p-type thermoelectric conversion layer 14b along the thickness direction D1 were set to 100µm, the maximum length of the sealing layer 15 along the thickness direction D1 was set to 150µm, the lengths of the first high thermal conduction portion 21, the second high thermal conduction portion 22 and the low thermal conduction portion 23 along the thickness direction D1 were set to 400µm, the lengths of the first electrode 12 and the second electrode 13 along the alignment direction D2 were set to 3mm, the lengths of the n-type thermoelectric conversion layer 14a and the p-type thermoelectric conversion layer 14b were set to 2.5mm, and the lengths of the first high thermal conduction portion 21 and the second high thermal conduction portion 22 along the alignment direction D2 were set to 3mm. In addition, the length of the high thermal conduction portion 110 along the thickness direction D1 was set to 400µm, and the length of the high thermal conduction portion 110 along the alignment direction D2 was set to 3mm.

In this simulation, in the thermoelectric conversion elements 1, 101, 201, 301, the thermal conductivities of the substrate 11 and the sealing layer 15 were set to 0.3W/mK, the thermal conductivities of the first electrode 12 and the second electrode 13 were set to 398W/mK, the thermal conductivities of the n-type thermoelectric conversion layer 14a and the p-type thermoelectric conversion layer 14b were set to 0.5W/mK, the thermal conductivities of the first high thermal conduction portion 21 and the second high thermal conduction portion 22 were set to 5.0W/mK, and the thermal conductivity of the low thermal conduction portion 23 was set to 0.05W/mK. The thermal conductivities of the high thermal conduction portions 110, 310 were set to 5.0W/mK, the thermal conductivity of the low thermal conduction portion 120 was set to 0.05W/mK, and the thermal conductivity of the low thermal conduction portion 220 was set to 0.1W/mK.

In the thermoelectric conversion elements 1, 101, 201, 301, the temperature on a side of heat source is set to 100°C, and the temperature on a side of air is set to room temperature (23°C), similarly to the third simulation described above. The temperature of the exposed surface of the sheet member 3 crossing the thickness direction D1 was also set to 100°C.

In the thermoelectric conversion elements 1, 101, 201, 301 set under the above-described conditions, the maximum temperature difference of the element portion 14 was simulated. As a result, the maximum temperature difference of the element portion 14 of the thermoelectric conversion element 1 was 5.259°C, the maximum temperature difference of the element portion 14 of the thermoelectric conversion element 101 was 4.909°C, the maximum temperature difference of the element portion 14 of the thermoelectric conversion element 201 was 4.785°C, and the maximum temperature difference of the element portion 14 of the thermoelectric conversion element 301 was 1.577°C. When the maximum temperature difference of the element portion 14 of the thermoelectric conversion element 101 was taken as a reference (100%), the maximum temperature difference of the element portion 14 of the thermoelectric conversion element 1 was 107%, the maximum temperature difference of the element portion 14 of the thermoelectric conversion element 201 was 87%, and the maximum temperature difference of the element portion 14 of the thermoelectric conversion element 301 was 32%. From the above results, it was suggested that in the configuration including the thermoelectric conversion element 1, when the outermost layer located on the first main face 11a of the substrate 11 is formed of the sealing layer 15, the thermoelectric conversion efficiency is likely to be the highest.

In the above-described embodiment, the outermost layer located on the first main face is formed only of the sealing layer, but the present disclosure is not limited thereto. For example, the outermost layer may include the sealing layer and a member different from the sealing layer.

In the above embodiment, one thermoelectric conversion module is provided on the first main face. For example, a plurality of thermoelectric conversion modules may be provided on the first main face. In this case, the plurality of thermoelectric conversion modules may be electrically connected to each other. In at least some of the thermoelectric conversion modules, the first electrode or the second electrode may be shared. When a plurality of thermoelectric conversion modules are provided on the first main face, the sheet member may include a high thermal conduction portion other than the first and the second high thermal conduction portions.

In the above embodiment, the first electrode and the second electrode are formed at the same time, however no limited thereto. The first and second electrodes may be formed from different materials.

### Reference Signs List

1, 101, 201, 301; thermoelectric conversion element
2; thermoelectric conversion module
3; sheet member
11; substrate
11a; First main face
11b; second main face
12; first electrode
13; second electrode
14; element portion
14a; n-type thermoelectric conversion layer
14b; p-type thermoelectric conversion layer
15; sealing layer
21; first high thermal conduction portion
22; second high thermal conduction portion
23; low thermal conduction portion
110, 310; high thermal conduction portion
120; 220 low thermal conduction portion
CP; contact portion
S1, S2; interval
T1; length of first high thermal conduction portion
T2; length of second high thermal conduction portion.

## Claims

1. A thermoelectric conversion element (1, 101, 201, 301) comprising:
a substrate (11) including a first main face (11a) and a second main face (11b) located on the opposite side of the first main face (11a);
a first electrode (12) provided on the first main face (11a), an n-type thermoelectric conversion layer (14a) electrically connected to the first electrode (12), a p-type thermoelectric conversion layer (14b) in contact with the n-type thermoelectric conversion layer (14a), and a second electrode (13) electrically connected to the p-type thermoelectric conversion layer (14b);
a sealing layer (15) provided on the first main face (11a), the sealing layer (15) covering the first electrode (12), the n-type thermoelectric conversion layer (14a), the p-type thermoelectric conversion layer (14b), and the second electrode (13); and
a first high thermal conduction portion (21), a second high thermal conduction portion (22), and a low thermal conduction portion (23) provided only on the second main face (11b),
wherein the first electrode (12), the n-type thermoelectric conversion layer (14a), the p-type thermoelectric conversion layer (14b), and the second electrode (13) are arranged in order along an alignment direction orthogonal to a thickness direction of the substrate (11),
wherein the first electrode (12) is overlapped with the first high thermal conduction portion (21) in the thickness direction, the second electrode (13) is overlapped with the second high thermal conduction portion (22) in the thickness direction, and a contact portion (CP) between the n-type thermoelectric conversion layer (14a) and the p-type thermoelectric conversion layer (14b) is overlapped with the low thermal conduction portion (23) in the thickness direction, and
wherein the sealing layer (15) constitutes an outermost layer located on the first main face (11a).

2. The thermoelectric conversion element (1, 101, 201, 301) according to claim 1, wherein a thermal conductivity of the low thermal conduction portion (23) is 0.2W/mK or less.

3. The thermoelectric conversion element (1, 101, 201, 301) according to claim 1 or 2, wherein a thermal conductivity of the low thermal conduction portion (23) is 0.08W/mK or less.

4. The thermoelectric conversion element (1, 101, 201, 301) according to any one of claims 1 to 3, wherein a thermal conductivity of the first high thermal conduction portion (21) and a thermal conductivity of the second high thermal conduction portion (22) are 5W/mK or more.

5. The thermoelectric conversion element (1, 101, 201, 301) according to any one of claims 1 to 4, wherein a thermal conductivity of the first electrode (12) and a thermal conductivity of the second electrode (13) are 5W/mK or more.

6. The thermoelectric conversion element (1, 101, 201, 301) according to any one of claims 1 to 5, wherein the substrate (11) has a flexibility.

7. The thermoelectric conversion element (1, 101, 201, 301) according to any one of claims 1 to 6,
wherein an interval from the first high thermal conduction portion (21) to the contact portion (CP) along the alignment direction is 5 times or more longer than a length of the first high thermal conduction portion (21) along the thickness direction; and
wherein an interval from the second high thermal conduction portion (22) to the contact portion (CP) along the alignment direction is 5 times or more longer than a length of the second high thermal conduction portion (22) along the thickness direction.

## Patentansprüche

1. Thermoelektrisches Umwandlungselement (1, 101, 201, 301), das Folgendes umfasst:
ein Substrat (11) mit einer ersten Hauptfläche (11a) und einer zweiten Hauptfläche (11b), die sich auf der gegenüberliegenden Seite der ersten Hauptfläche (11a) befindet;
eine erste Elektrode (12), die auf der ersten Hauptfläche (11a) vorgesehen ist, eine thermoelektrische Umwandlungsschicht vom n-Typ (14a), die elektrisch mit der ersten Elektrode (12) verbunden ist, eine thermoelektrische Umwandlungsschicht vom p-Typ (14b), die in Kontakt mit der thermoelektrischen Umwandlungsschicht vom n-Typ (14a) steht, und eine zweite Elektrode (13), die elektrisch mit der thermoelektrischen Umwandlungsschicht vom p-Typ (14b) verbunden ist;
eine Dichtungsschicht (15), die auf der ersten Hauptfläche (11a) vorgesehen ist, wobei die Dichtungsschicht (15) die erste Elektrode (12), die thermoelektrische Umwandlungsschicht vom n-Typ (14a), die thermoelektrische Umwandlungsschicht vom p-Typ (14b) und die zweite Elektrode (13) bedeckt; und
einen ersten hoch wärmeleitenden Abschnitt (21), einen zweiten hoch wärmeleitenden Abschnitt (22) und einen niedrig wärmeleitenden Abschnitt (23), die nur auf der zweiten Hauptfläche (11b) vorgesehen sind,
wobei die erste Elektrode (12), die thermoelektrische Umwandlungsschicht vom n-Typ (14a), die thermoelektrische Umwandlungsschicht vom p-Typ (14b) und die zweite Elektrode (13) in der Reihenfolge entlang einer Ausrichtungsrichtung orthogonal zu einer Dickenrichtung des Substrats (11) angeordnet sind,
wobei die erste Elektrode (12) mit dem ersten hoch wärmeleitenden Abschnitt (21) in der Dickenrichtung überlappt ist, die zweite Elektrode (13) mit dem zweiten hoch wärmeleitenden Abschnitt (22) in der Dickenrichtung überlappt ist und ein Kontaktabschnitt (CP) zwischen der thermoelektrischen Umwandlungsschicht vom n-Typ (14a) und der thermoelektrischen Umwandlungsschicht vom p-Typ (14b) mit dem niedrig wärmeleitenden Abschnitt (23) in der Dickenrichtung überlappt ist, und
wobei die Dichtungsschicht (15) eine äußerste Schicht bildet, die sich auf der ersten Hauptfläche (11a) befindet.

2. Thermoelektrisches Umwandlungselement (1, 101, 201, 301) nach Anspruch 1, wobei die Wärmeleitfähigkeit des niedrig wärmeleitenden Abschnitts (23) 0,2 W/mK oder weniger beträgt.

3. Thermoelektrisches Umwandlungselement (1, 101, 201, 301) nach Anspruch 1 oder 2, wobei die Wärmeleitfähigkeit des niedrig wärmeleitenden Abschnitts (23) 0,08 W/mK oder weniger beträgt.

4. Thermoelektrisches Umwandlungselement (1, 101, 201, 301) nach einem der Ansprüche 1 bis 3, wobei die Wärmeleitfähigkeit des ersten hoch wärmeleitenden Abschnitts (21) und die Wärmeleitfähigkeit des zweiten hoch wärmeleitenden Abschnitts (22) 5 W/mK oder mehr betragen.

5. Thermoelektrisches Umwandlungselement (1, 101, 201, 301) nach einem der Ansprüche 1 bis 4, wobei die Wärmeleitfähigkeit der ersten Elektrode (12) und die Wärmeleitfähigkeit der zweiten Elektrode (13) 5 W/mK oder mehr betragen.

6. Thermoelektrisches Umwandlungselement (1, 101, 201, 301) nach einem der Ansprüche 1 bis 5, wobei das Substrat (11) eine Flexibilität aufweist.

7. Thermoelektrisches Umwandlungselement (1, 101, 201, 301) nach einem der Ansprüche 1 bis 6,
wobei ein Abstand von dem ersten hoch wärmeleitenden Abschnitt (21) zu dem Kontaktabschnitt (CP) entlang der Ausrichtungsrichtung 5 mal oder mehr länger ist als eine Länge des ersten hoch wärmeleitenden Abschnitts (21) entlang der Dickenrichtung; und
wobei ein Abstand von dem zweiten hoch wärmeleitenden Abschnitt (22) zu dem Kontaktabschnitt (CP) entlang der Ausrichtungsrichtung 5 mal oder mehr länger ist als eine Länge des zweiten hoch wärmeleitenden Abschnitts (22) entlang der Dickenrichtung.

## Revendications

1. Élément de conversion thermoélectrique (1, 101, 201, 301) comprenant :
un substrat (11) comprenant une première face principale (11a) et une deuxième face principale (11b) située sur le côté opposé de la première face principale (11a) ;
une première électrode (12) prévue sur la première face principale (11a), une couche de conversion thermoélectrique de type n (14a) connectée électriquement à la première électrode (12), une couche de conversion thermoélectrique de type p (14b) en contact avec la couche de conversion thermoélectrique de type n (14a), et une deuxième électrode (13) connectée électriquement à la couche de conversion thermoélectrique de type p (14b) ;
une couche d'étanchéité (15) prévue sur la première face principale (11a), la couche d'étanchéité (15) recouvrant la première électrode (12), la couche de conversion thermoélectrique de type n (14a), la couche de conversion thermoélectrique de type p (14b) et la deuxième électrode (13) ; et
une première partie à forte conduction thermique (21), une deuxième partie à forte conduction thermique (22), et une partie à faible conduction thermique (23) prévues uniquement sur la deuxième face principale (11b),
dans lequel la première électrode (12), la couche de conversion thermoélectrique de type n (14a), la couche de conversion thermoélectrique de type p (14b) et la deuxième électrode (13) sont disposées dans l'ordre le long d'une direction d'alignement orthogonale à une direction d'épaisseur du substrat (11),
dans lequel la première électrode (12) est chevauchée par la première partie à forte conduction thermique (21) dans la direction de l'épaisseur, la deuxième électrode (13) est chevauchée par la deuxième partie à forte conduction thermique (22) dans la direction de l'épaisseur, et une partie de contact (CP) entre la couche de conversion thermoélectrique de type n (14a) et la couche de conversion thermoélectrique de type p (14b) est chevauchée par la partie à faible conduction thermique (23) dans la direction de l'épaisseur, et...
dans lequel la couche d'étanchéité (15) constitue une couche extérieure située sur la première face principale (11a).

2. Élément de conversion thermoélectrique (1, 101, 201, 301) selon la revendication 1, dans lequel une conductivité thermique de la partie à faible conduction thermique (23) est inférieure ou égale à 0,2W/mK.

3. Élément de conversion thermoélectrique (1, 101, 201, 301) selon la revendication 1 ou 2, dans lequel une conductivité thermique de la partie à faible conduction thermique (23) est inférieure ou égale à 0,08W/mK.

4. Élément de conversion thermoélectrique (1, 101, 201, 301) selon l'une quelconque des revendications 1 à 3, dans lequel une conductivité thermique de la première partie à forte conduction thermique (21) et une conductivité thermique de la deuxième partie à forte conduction thermique (22) sont supérieures ou égales à 5W/mK.

5. Élément de conversion thermoélectrique (1, 101, 201, 301) selon l'une quelconque des revendications 1 à 4, dans lequel une conductivité thermique de la première électrode (12) et une conductivité thermique de la deuxième électrode (13) sont supérieures ou égales à 5W/mK.

6. Élément de conversion thermoélectrique (1, 101, 201, 301) selon l'une quelconque des revendications 1 à 5, dans lequel le substrat (11) présente une flexibilité.

7. Élément de conversion thermoélectrique (1, 101, 201, 301) selon l'une quelconque des revendications 1 à 6,
dans lequel un intervalle entre la première partie à forte conduction thermique (21) et la partie de contact (CP) le long de la direction d'alignement est 5 fois ou plus long que la longueur de la première partie à forte conduction thermique (21) le long de la direction d'épaisseur ; et
dans lequel un intervalle entre la deuxième partie à forte conduction thermique (22) et la partie de contact (CP) le long de la direction d'alignement est 5 fois ou plus long qu'une longueur de la deuxième partie à forte conduction thermique (22) le long de la direction d'épaisseur.
